(19) **Europäisches Patentamt**
**European Patent Office**
**Office européen des brevets**

(11) **EP 2 529 243 B1**

(12) **FASCICULE DE BREVET EUROPEEN**

(45) Date de publication et mention
de la délivrance du brevet:
**19.03.2014 Bulletin 2014/12**

(51) Int Cl.:
***G01R 33/00*** *(2006.01)*   ***G01R 33/02*** *(2006.01)*
***G01R 33/09*** *(2006.01)*

(21) Numéro de dépôt: **11708900.3**

(22) Date de dépôt: **28.01.2011**

(86) Numéro de dépôt international:
**PCT/FR2011/000058**

(87) Numéro de publication internationale:
**WO 2011/092406 (04.08.2011 Gazette 2011/31)**

(54) **MAGNETOMETRE INTEGRE ET SON PROCEDE DE FABRICATION**

INTEGRIERTES MAGNETOMETER UND HERSTELLUNGSVERFAHREN

INTEGRATED MAGNETOMETER AND ITS MANUFACTURING PROCESS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.01.2010 FR 1000369**

(43) Date de publication de la demande:
**05.12.2012 Bulletin 2012/49**

(73) Titulaires:
• **Centre National de la Recherche Scientifique**
  **75016 Paris (FR)**
• **Commissariat à l'Énergie Atomique**
  **et aux Énergies Alternatives**
  **75015 Paris (FR)**

(72) Inventeurs:
• **SCHUHL, Alain**
  **F-38000 Grenoble (FR)**

• **GAUDIN, Gilles**
  **F-38700 Le Sappey (FR)**
• **SABON, Philippe**
  **F-38430 Moirans (FR)**
• **ZERMATTEN, Pierre-Jean**
  **J1J 1N2, Sherbrooke**
  **Ca, Qc. (CA)**
• **MONTAIGNE, François**
  **F-54000 Nancy (FR)**

(74) Mandataire: **Priori, Enrico et al**
**Cabinet Orès**
**36, rue de St. Pétersbourg**
**75008 Paris (FR)**

(56) Documents cités:
**FR-A1- 2 639 717     US-A- 5 689 185**
**US-A1- 2002 092 364     US-A1- 2008 169 807**
**US-A1- 2009 027 048**

EP 2 529 243 B1

## Description

L'invention porte sur un magnétomètre intégré à deux ou trois axes, ainsi que sur son procédé de fabrication.

Il est connu de l'art antérieur de réaliser des magnétomètres intégrés basés sur des capteurs magnétorésistifs multicouches, exploitant les effets de magnétorésistance géante ou de magnétorésistance tunnel. Voir par exemple les articles suivants :

- M. Hehn, F. Montaigne et A. Schuhl « Magnétorésistance géante et électronique de spin », Techniques de l'Ingénieur, E 2 135, chapitres 1 et 2 ;
- J. Daughton et al. « Magnetic Field Sensors Using GMR Multilayer », IEEE Transactions on magnetics, Vol. 30, n°6, Novembre 1994 ;
- M. Tondra et al. « Picotesla field sensor design using spin-dependent tunneling devices », Journal of Applied Physics, Vol. 83, n°11, pages 6688-6690, 1er juin 1998.

Ces capteurs magnétorésistifs sont constitués par un empilement de couches minces, déposées sur un substrat planaire, par exemple en silicium.

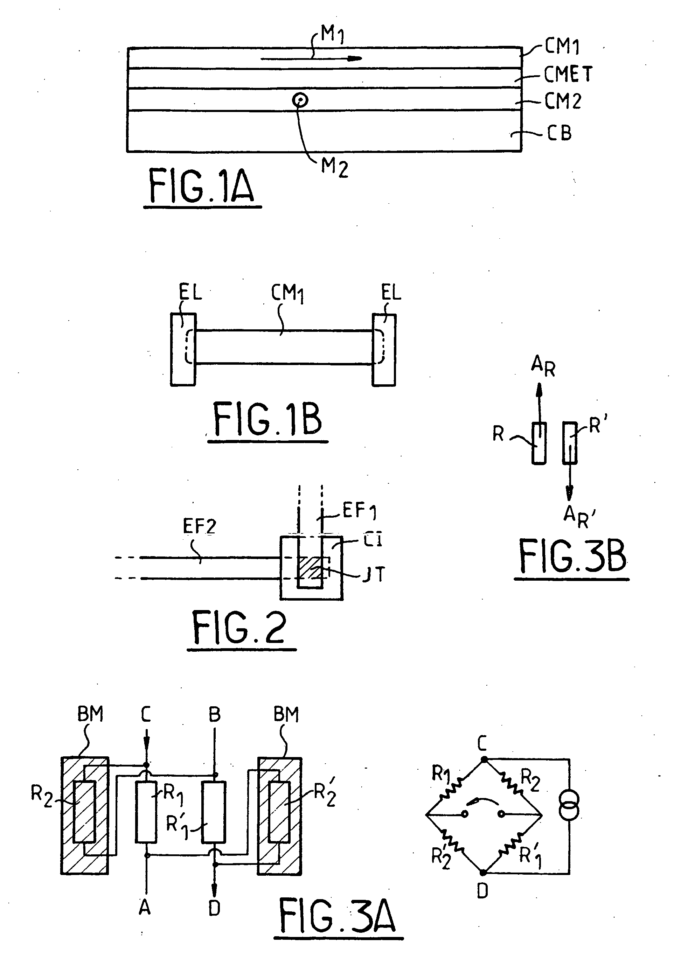

Plus précisément, comme le montre la figure 1A, un capteur magnétorésistif à magnétorésistance géante (GMR, de l'anglais « Giant MagnetoResistance) est constitué de deux couches magnétiques, CM1 et CM2, par exemple en cobalt, séparées par une couche métallique CMET, par exemple en cuivre, dont l'épaisseur est de l'ordre du nanomètre. La couche inférieure CM2 est dite « dure », car son aimantation (moment magnétique) $M_2$ est rendue insensible à tout champ magnétique externe (tant que ce dernier n'est pas trop intense), tandis que la couche supérieure CM1 est dite douce car son moment magnétique $M_1$ est susceptible d'être modifié par un champ magnétique externe d'intensité modérée. L'aimantation de la couche « dure » est obtenue en déposant cette dernière sur une couche antiferromagnétique, dite couche de blocage CB. L'aimantation de la couche « douce » est obtenue par recuit au-dessus de la température de Curie, suivi par un refroidissement en présence d'un champ magnétique ayant une direction appropriée.

La résistance électrique de cette structure, mesurée parallèlement aux couches CM1 et CM2, dépend du cosinus de l'angle $\theta$ entre $M_1$ et $M_2$. Afin d'obtenir une réponse linéaire, on choisit généralement $M_1$ et $M_2$ perpendiculaires entre elles en l'absence de champ magnétique externe.

Lorsqu'un champ magnétique externe B est appliqué à la structure de la figure 1, le moment magnétique de la couche « douce », $M_1$, tourne et l'angle $\theta$ change. Au premier ordre, seule la composante du champ B perpendiculaire à $M_1$ et située dans le plan des couches agit sur l'orientation du capteur. En d'autres termes, lorsque les deux aimantations M1 et M2 sont perpendiculaires en l'absence de champ magnétique, le capteur est sensible uniquement à la composante du champ orientée suivant la direction de l'aimantation $M_2$ de sa couche « dure ».

Dans un capteur GMR, le courant électrique circule parallèlement aux plans des couches. Par conséquent, un tel capteur se présente sous la forme d'une bande fine et allongée, avec des électrodes EL à ses extrémités (figure 1 B)

Un second type de capteur, le capteur magnétorésistif à effet tunnel (TMR : de l'anglais Tunnel MagnetoResistance) est aussi composé de deux couches EF1, EF2 d'un matériau ferromagnétique conducteur, par exemple, Co, Fe ou CoFe, qui peuvent être identiques ou différentes (« électrodes ») séparées d'une fine couche CI (épaisseur typiquement comprise entre 0,8 et 5 nm) d'isolant tel que l'alumine - $Al_2O_3$ - ou l'oxyde de magnésium - MgO. Comme dans le cas des capteurs GMR, l'aimantation de l'électrode inférieure EF2 est fixe, tandis que celle de l'électrode supérieure peut être modifiée par un champ magnétique externe. La probabilité qu'un électron franchisse par effet tunnel la barrière d'isolant, et donc la résistance de la jonction tunnel JT, dépend du cosinus de l'angle $\theta$ entre les aimantations entre les deux couches magnétiques. Comme un capteur GMR, lorsque les aimantations des couches EF1 et EF2 sont perpendiculaires en l'absence de champ magnétique, un capteur TMR est sensible uniquement à la composante du champ orientée suivant la direction de l'aimantation de son électrode « dure ».

Dans un capteur TMR, le courant électrique circule perpendiculairement aux plans des couches. Par conséquent, un tel capteur se présente sous la forme de deux bandes croisées, constituées par les électrodes ferromagnétiques EF1, EF2, séparées par la couche CI, comme illustré sur la figure 2.

Dans les capteurs magnétorésistifs, qu'ils soient de type GMR ou TMR, se pose le problème de l'élimination du « décalage » (ou « offset »), c'est-à-dire de la composante de résistance indépendante du champ magnétique. Ce décalage est important et dépend de la température.

Une première possibilité pour éliminer ce décalage, illustrée sur la figure 3A, consiste à cointégrer sur un même substrat quatre capteurs identiques $R_1$, $R_1'$, $R_2$, $R_2'$, avec des axes de sensibilité parallèles entre eux. Ces quatre capteurs sont connectés de manière à former un pont de Wheatstone, avec un premier bras formé par les capteurs $R_1$ et $R_2$ et un deuxième bras formé par les capteurs $R_1'$ et $R_2'$. Les capteurs $R_2$ et $R'_2$, appartenant à des bras différents et occupant des positions opposées dans le pont de Wheatstone (c'est-à-dire n'étant pas connectés directement entre eux) sont recouverts par un blindage magnétique BM en alliage ferromagnétique doux. Ainsi, seules les résistances de $R_1$ et $R_1'$ dépendent du champ magnétique externe. Si on connecte les points C, D du pont à un générateur de courant, la différence de potentiel entre les points A et B est proportionnelle à cos(θ), et donc à la composante du champ magnétique externe susceptible d'être mesurée. En fait, il n'est pas essentiel que les quatre capteurs soient identiques : il suffit que les résistances de $R_1$ et $R_1$' soient égales entre elles, ainsi que celles de $R_2$ et $R_2$', et que le décalage des quatre capteurs présente la même dépendance de la température.

Comme le montre la figure 3B, une deuxième solution pour éliminer le décalage consiste à effectuer une mesure différentielle de résistance entre deux capteurs R, R' identiques et présentant une réponse de signe opposé à une même composante de champ magnétique (flèches $A_R$, $A_{R'}$). Deux capteurs de ce type doivent présenter des aimantations opposées de leurs couches « dures ». Cela peut être obtenu de plusieurs façons, en particulier :

- en intégrant sur le substrat un réseau de lignes électriques permettant d'appliquer localement des champs magnétiques de directions différentes ; ou
- en déposant l'un des capteurs sur une structure multicouche particulière, connue comme « système antiferromagnétique artificiel » (ou « AAF », de l'anglais « Artificial Antiferromagnet », qui est à son tour déposée sur la couche de blocage. La structure AAF est constituée par deux couches magnétiques séparées par un espaceur métallique qui induit un couplage antiferromagnétique entre elles. A cause de ce couplage, les aimantations des deux couches restent constamment dans un alignement antiparallèle : ainsi, la couche « dure » du capteur est polarisée dans une direction opposée au moment magnétique de la couche de blocage.

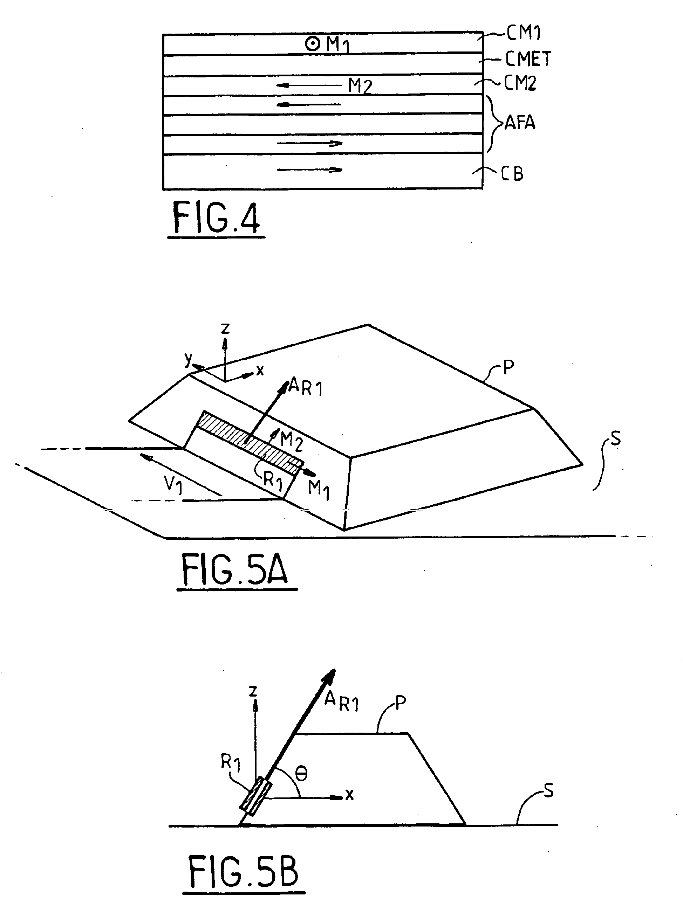

La figure 4 monte une vue en coupe d'un capteur comportant un AAF. L'utilisation d'une structure AAF dans un capteur GMR est délicate, car ladite structure augmente la conductivité du capteur et en décroit donc la sensibilité. Ce problème ne se pose pas dans le cas d'un capteur TMR.

L'art antérieur ne permet pas de réaliser un magnétomètre intégré à trois axes: tout au plus, les capteurs magnétorésistifs déposés sur un substrat planaire permettent de mesurer les deux composantes de la projection d'un champ magnétique externe sur le plan du substrat. Conformément à l'art antérieur, un magnétomètre à trois axes est généralement réalisé sous forme hybride, utilisant au moins deux substrats non coplanaires. Il en résulte des dispositifs coûteux à réaliser, encombrants et délicats, et surtout présentant une précision limitée par des erreurs systématiques liées à l'assemblage du magnétomètre.

La réalisation d'un magnétomètre à un ou deux axes est possible mais, comme on vient de le voir, nécessite la mise en oeuvre de techniques relativement complexes d'élimination du décalage.

Les documents US 2009/027048 et US 2008/169807 décrivent des magnétomètres à trois axes intégrés comprenant des capteurs magnétorésistifs déposés sur la surface plane d'un substrat avec deux orientations différentes, ainsi que d'autres capteurs déposés sur des faces inclinées obtenues en gravant des rainures sur ladite surface. Les capteurs déposés sur la surface plane permettent de mesurer le champ magnétique en deux dimensions ; les capteurs déposés sur les faces inclinées des rainures donnent accès à la troisième dimension. Le problème de l'élimination du décalage, et de sa dérive, demeure entier.

L'invention vise à surmonter les inconvénients précités de l'art antérieur.

Un objet de l'invention permettant d'atteindre ce but est un magnétomètre intégré selon la revendication 1, comportant une pluralité de capteurs magnétorésistifs multicouches déposés sur une surface dite supérieure d'un substrat sensiblement planaire, caractérisé en ce que :

- ladite surface supérieure du substrat présente au moins une cavité ou protubérance pourvue d'une pluralité de faces inclinées ; et en ce que:
- au moins quatre dits capteurs magnétorésistifs sont déposés sur quatre dites faces inclinées, présentant des orientations différentes et opposées deux à deux, chaque capteur étant sensible à une composante d'un champ magnétique externe parallèle à la face sur lequel il est déposé.

Des modes de réalisation avantageux du magnétomètre selon l'invention font l'objet des revendications dépendantes.

Un autre objet de l'invention est un procédé de fabrication d'un magnétomètre tel que décrit ci-dessus comportant :

- une première étape de réalisation de ladite ou de chaque cavité ou protubérance sur ladite surface supérieure dudit substrat ;
- une deuxième étape de réalisation desdits capteurs magnétorésistifs multicouches par des opérations successives de dépôt et de lithographie ; et
- une troisième étape de recuit avec application d'un champ magnétique externe pour déterminer les axes de sensibilité des capteurs ainsi réalisés.

Selon des modes de réalisation particuliers de ce procédé :

- Ladite première étape peut être mise en oeuvre par gravure anisotrope dudit substrat, qui doit alors être monocristallin.
- Ladite deuxième étape peut comporter au moins une opération de dépôt d'une couche homogène de résine sur la surface dudit substrat, ladite ou chaque opération de dépôt étant réalisée par nébulisation ou vaporisation de ladite résine.

D'autres caractéristiques, détails et avantages de l'invention ressortiront à la lecture de la description faite en référence aux dessins annexés donnés à titre d'exemple et qui représentent, respectivement :

- les figures 1A, 1B, 2, 3A, 3B et 4, déjà décrites, des capteurs magnétorésistifs intégrés connus de l'art antérieur ;
- les figures 5A et 5B, respectivement, une vue en élévation et en coupe d'une protubérance en forme de pyramide tronquée, obtenue pour gravure anisotrope d'un substrat en silicium monocristallin, sur une face de laquelle a été déposé un capteur magnétorésistif de type GMR ;
- la figure 6, une vue en coupe d'un magnétomètre à un axe basé sur des capteurs de type GMR ;
- la figure 7, une vue en plan d'un magnétomètre à deux axes selon un mode de réalisation de l'invention, également basé sur des capteurs de type GMR ;
- la figure 8, une vue en plan d'un magnétomètre à trois axes selon un autre mode de réalisation de l'invention, également basé sur des capteurs de type GMR ;
- la figure 9, une vue en plan d'un magnétomètre à trois axes selon encore un autre mode de réalisation de l'invention, basé sur des capteurs de type TMR ;
- la figure 10, une vue en élévation d'un magnétomètre selon l'invention cointégré avec un accéléromètre ;
- la figure 11, une illustration simplifiée des différentes étapes de fabrication d'un magnétomètre selon le procédé de l'invention ;
- la figure 12, une vue en plan d'un magnétomètre selon une variante de l'invention, comprenant des concentrateurs de flux ; et
- les figures 13A et 13B, une vue en plan d'un magnétomètre constitué par une connexion en série de plusieurs magnétomètres du type représenté sur la figure 7.

Les figures 5A et 5B se rapportent au cas où un seul capteur magnétorésistif de type GMR, $R_1$, est déposé sur une face d'une protubérance P en forme de pyramide tronquée, réalisée par gravure anisotrope d'un substrat S en silicium monocristallin dont la surface correspond au plan cristallin 100. Dans ces conditions, les quatre faces de la pyramide correspondent à des plans 111, et sont inclinées d'un angle $\theta=54,7°$ par rapport à la surface du substrat. La réalisation de protubérances de ce type - ainsi que de cavités également en forme de pyramide tronquée - a été décrite dans l'article de Chii-Rong Yang et al. « Study on anisotropic silicon etching characteristics in various surfactant-added teramethyl ammonium hydroxide water solutions». J. Micromech. Microeng. 15, 2028 (2005).

Sur la figure $M_1$ représente le moment d'aimantation de la couche sensible (douce) de $R_1$, $M_2$ celui de la couche dure, $A_{R1}$ l'axe de détection du capteur, parallèle à $M_2$. La surface du substrat S est parallèle au plan xy, et perpendiculaire à l'axe z. On appelle $B_x$, $B_y$ et $B_z$ les composantes le long des axes x, y et z, respectivement, d'un champ magnétique externe à mesurer.

Un courant connu parcourt le capteur $R_1$ dans une direction parallèle à l'axe y ; la tension $V_1$ mesurée à ses bornes permet de déterminer sa résistance, qui est fonction de $B_x$ et $B_z$, mais pas de $B_y$. Dans la limite de la réponse linéaire du capteur, son signal de sortie est donné par :

$$V_1 = V_0 + S\left[B_z \sin\theta + B_x \cos\theta\right]$$

où S est la sensibilité du capteur et $V_0$ son décalage (« offset »), c'est-à-dire sa tension de sortie en l'absence de champ magnétique.

Le dispositif de la figure 5 présente un intérêt limité, car à cause du décalage il est difficile d'associer une mesure de tension à la valeur d'une composante du champ magnétique.

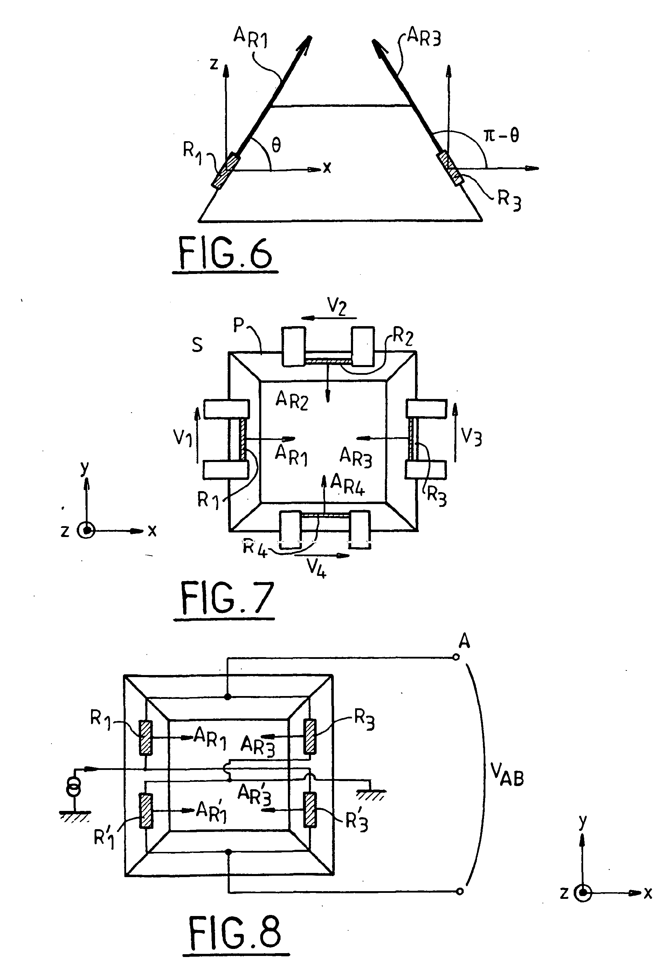

La figure 6 montre un dispositif dans lequel deux capteurs identiques $R_1$ et $R_3$ sont déposés sur deux faces opposées de la pyramide P. Les signaux de sortie $V_1$ et $V_2$ permettent de déterminer $B_x$, en s'affranchissant du décalage $V_0$ :

$$B_x = \frac{1}{2\cos\theta}\frac{V_1 - V_3}{S}$$

En revanche, la mesure de la composante $B_z$ dépend du décalage :

$$B_z = \frac{1}{2\cos\theta}\frac{V_1 + V_3 - 2V_0}{S}$$

Pour s'affranchir du décalage qui affecte la mesure de la composante $B_z$, il est possible de remplacer les capteurs $R_1$, $R_3$ par deux ensembles de quatre capteurs montés en pont de Wheatstone du type représenté sur la figure 3 précipitée. En variante, il est possible de remplacer ces capteurs par des paires de capteurs ayant des axes de sensibilités parallèles et des sensibilités S opposées, comme expliqué plus haut.

La figure 7 montre un dispositif selon un mode de réalisation de l'invention, dans lequel quatre capteurs identiques $R_1$, $R_2$, $R_3$ et $R_4$ sont déposés sur les quatre faces de la pyramide P, avec leurs axes de sensibilité $A_{R1}$, $A_{R2}$, $A_{R3}$ et $A_{R4}$ orientés vers la pointe. Ce magnétomètre permet de déterminer $B_x$ et $B_y$, réalisant ainsi une « boussole » :

$$B_x = \frac{1}{2\cos\theta}\frac{V_1 - V_3}{S}$$

$$B_y = \frac{1}{2\cos\theta}\frac{V_2 - V_4}{S}$$

Si seule l'orientation du champ magnétique dans le plan xy est recherchée, la connaissance de la sensibilité S n'est pas requise.

Comme dans le cas de la figure 6, pour mesurer $B_z$ il est nécessaire de remplacer les capteurs $R_1$, $R_2$, $R_3$ et $R_4$ par des montages en pont de Wheatstone du type illustré sur la figure 3 ou par des paires de capteurs ayant des axes de sensibilités parallèles et des sensibilités S opposées.

La figure 8 montre un dispositif selon un autre mode de réalisation de l'invention, qui se différencie du premier mode de réalisation en ce que les capteurs déposés sur les deux faces d'orientation opposée sont dédoublés en deux capteurs élémentaires identiques : $R_1$, $R_1'$, et $R_3$, $R_3'$. Les quatre capteurs élémentaires sont connectés en pont de Wheatstone, comme représenté sur la figure. La tension $V_{AB}$ est directement proportionnelle à $B_x$, ce qui simplifie l'électronique de traitement des mesures et permet d'en augmenter la dynamique, car il n'est plus nécessaire d'amplifier, et éventuellement de convertir en format numérique, la composante $V_0$ des signaux de tension mesurés.

Une structure en pont peut également être réalisée sur les deux autres faces de la protubérance P, donnant accès à un signal indicatif de la composante $B_y$ du champ magnétique.

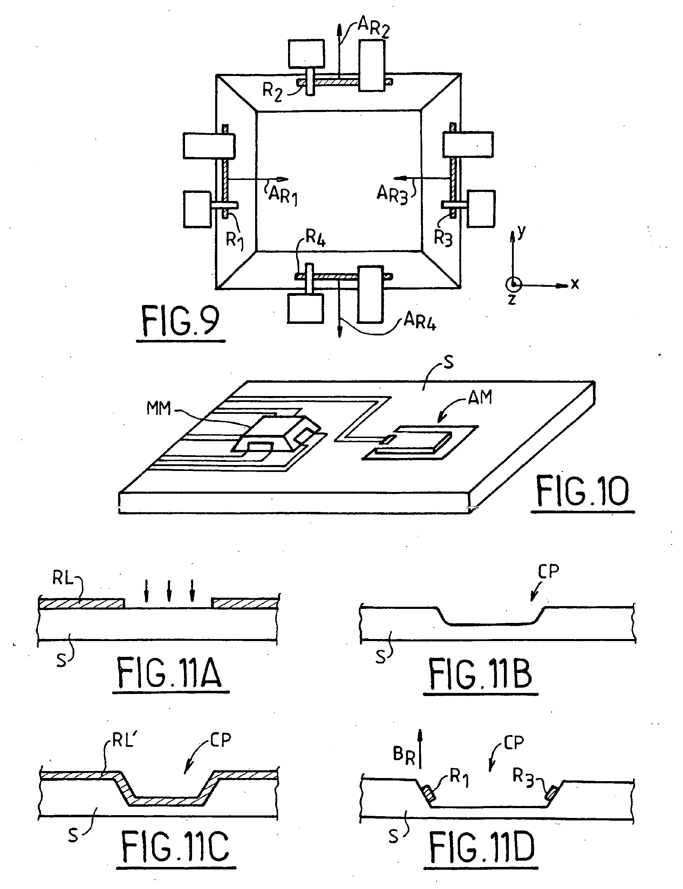

La figure 9 montre un dispositif selon encore un autre mode de réalisation de l'invention, qui se différencie de celui de la figure 7 seulement en ce que les capteurs $R_2$ et $R_4$ comportent une structure AAF qui inverse leur sensibilité (les flèches $A_{R2}$ et $A_{R4}$ sont orientées à l'opposée de la pointe de la pyramide P). Les trois composantes du champ magnétique sont données par :

$$B_x = \frac{1}{2\cos\theta}\frac{V_1 - V_3}{S}$$

$$B_y = \frac{1}{2\cos\theta}\frac{V_2 - V_4}{S}$$

$$B_z = \frac{1}{4\sin\theta}\frac{V_1 + V_3 - (V_2 + V_4)}{S}$$

On s'est donc affranchis complètement du décalage $V_0$.

Pour réaliser un magnétomètre du type de la figure 9, il suffit de masquer les zones destinées au dépôt de capteurs $R_1$ et $R_3$ lors du dépôt de la structure AAF. Comme expliqué plus haut, cette solution convient mieux aux capteurs TMR (représentés sur la figure 9) qu'aux capteurs GMR. Comme expliqué plus haut, il existe aussi une alternative à l'utilisation d'une structure AAF : il suffit pour cela de réaliser sur le substrat un réseau de lignes électriques permettant d'appliquer localement des champs magnétiques de directions différentes.

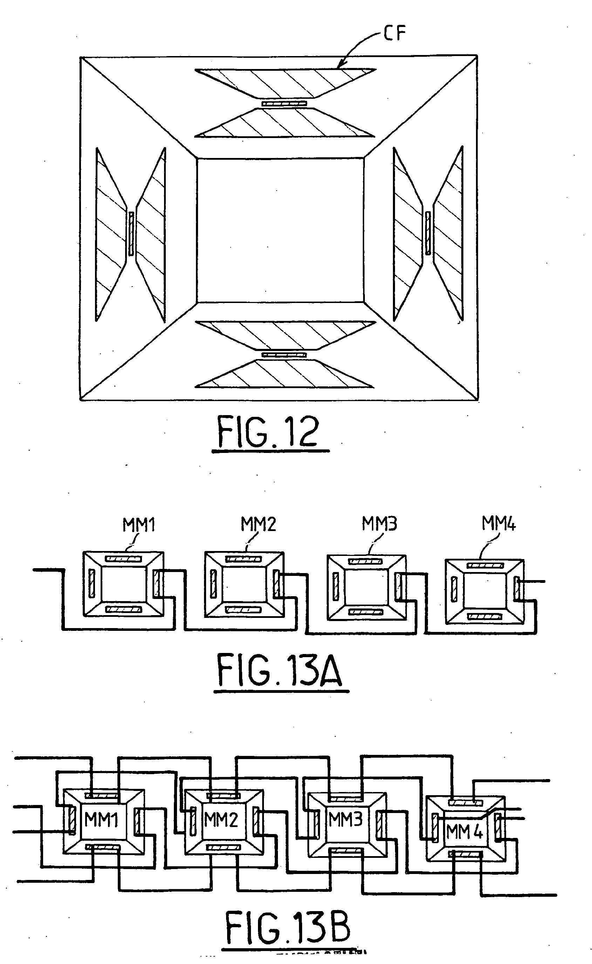

Afin d'accroitre la sensibilité d'un magnétomètre selon l'invention, il est possible de prévoir des concentrateurs de flux CF sur les faces inclinées portant les capteurs magnétorésistifs. Chaque concentrateur de flux est constitué par deux pièces planaires en matériau magnétique doux à haute perméabilité (par exemple : permalloy), ayant une forme trapézoïdale et se faisant face par leur plus petite base, leur hauteur étant parallèle à l'axe de sensibilité du capteur magnétorésistif (et donc étant orientée vers la base de la pyramide). Ces deux pièces concentrent les lignes de flux du champ magnétique dans la région entre leurs plus petites bases, où se trouve le capteur. Cette variante est illustrée sur la figure 12.

Les figures 13A et 13B illustrent un magnétomètre « complexe » constitué par une pluralité (quatre, en l'espèce) de magnétomètres élémentaires MM1 - MM4 tels que décrits ci-dessus, dans lesquels les capteurs correspondants - c'est-à-dire ayant des axes de sensibilité parallèles entre eux - sont connectés en série. Cela permet d'augmenter le rapport signal sur bruit ; lorsque des capteurs TMR sont utilisés, cela diminue aussi le risque de claquage des jonctions tunnel. Les magnétomètres élémentaires doivent être disposés à proximité immédiate les uns des autres (quelques millimètres ou moins, de préférence 1 mm ou moins) afin d'être soumis au même champ magnétique. Dans un souci de lisibilité, la figure 13A montre un cas simplifié, où seulement un capteur de chaque magnétomètre élémentaire est connecté en série avec les capteurs correspondants des autres magnétomètres ; la figure 13B montre le cas où les quatre branches de chaque magnétomètre élémentaire participent à une connexion en série. Bien entendu, le nombre de magnétomètres élémentaires peut être différent de quatre ; ces magnétomètres élémentaires ne doivent pas nécessairement être alignés ; ils peuvent aussi, par exemple, être agencés en matrice.

L'invention a été décrite en référence à des modes de réalisation basés sur l'utilisation de capteurs identiques entre eux (sauf, le cas échéant, en ce qui concerne le signe de leur sensibilité S). Il ne s'agit pas là d'une limitation essentielle, et des magnétomètres formés par une pluralité de capteurs magnétorésistifs différents ne sont pas exclus du champ de l'invention. Cependant, l'utilisation de capteurs identiques est préférée, car elle permet de minimiser les erreurs systématiques. La co-intégration monolithique des différents capteurs est avantageuse, entre autres, en ce qu'elle permet justement d'assurer l'identité substantielle de leurs caractéristiques. Dans ce même but, on déposera de préférence les capteurs à proximité immédiate les uns des autres ; typiquement, tous les capteurs d'un même magnétomètre selon l'invention seront compris dans un rayon de 1 mm ou moins, de préférence de 100 μm ou moins et de manière encore préférée de 50 μm ou moins.

L'invention a été décrite en référence à des modes de réalisation basés sur l'utilisation de cavités ou protubérances de forme pyramidale. Cependant, il ne s'agit pas là d'une limitation essentielle ; ce qui est important est qu'au moins quatre capteurs magnétorésistifs soient déposés, ou plus généralement agencés, sur quatre faces inclinées, présentant des orientations différentes entre elles et opposées deux à deux. Une pyramide, éventuellement tronquée, présente quatre faces satisfaisant cette condition. En variante, on pourrait avoir recours à deux rainures en « V », non parallèles (et de préférence perpendiculaires) entre elles, par exemple formant un chevron.

La figure 10 montre une vue en élévation d'un magnétomètre MM du type de la figure 9, cointégré avec un accéléromètre microéléctromécanique AM à levier encastré, sensible le long de l'axe z. Lorsque le dispositif est au repos, l'accéléromètre mesure la composante de l'accélération de pesanteur g le long de l'axe z, ce qui permet de déterminer l'inclinaison de cet axe par rapport à la verticale. On peut ainsi déterminer les composantes du champ magnétique B parallèles et perpendiculaire à la verticale locale. Bien entendu, des accéléromètres de type différents, à un ou trois axes, peuvent être utilisés.

Le magnétomètre de l'invention est généralement connecté, au moyen de lignes conductrices déposées sur le substrat S par des techniques classiques de la microélectronique, à un circuit électronique de traitement. Ce circuit, de type numérique, analogique ou hybride numérique/analogique, permet d'effectuer les mesures de résistance et de traiter les résultats de ces mesures pour déterminer le composantes recherchées du champ magnétique. Avantageusement, ce circuit peut être cointégré sur le substrat S.

Les figures 11A - 11D illustrent très schématiquement les différentes étapes d'un procédé de fabrication d'un magnétomètre selon l'invention.

La première étape est la gravure chimique anisotrope de la surface 100 du silicium, par attaque chimique, révélant les plans 111 plus denses et inclinés de 54,7°. La figure 11A montre le substrat S recouvert d'une couche de résine RL, dans laquelle a été dégagée une ouverture permettant l'attaque chimique de la surface du substrat. La figure 11 B montre la cavité en forme de pyramide tronquée CP obtenue à la fin de l'opération de gravure anisotrope, après élimination de la résine. En variante, il est possible d'obtenir des protubérances de la même forme en enlevant la résine partout sauf sur une région de forme carrée ou rectangulaire. Cette étape est bien connue dans la technique, et décrite notamment par l'article précité de Chii-Rong Yang et al.

La deuxième étape est la réalisation des capteurs magnétorésistifs et de leurs connexions électriques, par des opérations conventionnelles de dépôt et lithographie. Une difficulté est représentée par le fait que les opérations de lithographie nécessitent de déposer des couches homogènes de résine sur les faces inclinées des cavités ou protubérances. La technique conventionnelle de dépôt à la tournette (« spincoating ») n'est pas adaptée car elle laisserait les pentes dégarnies. Il existe cependant des techniques de dépôt par nébulisation (« spraycoating ») ou évaporation de résine, qui permettent de réaliser des couches homogènes de résine même sur des surfaces inclinées. Voir par exemple les publications suivantes :

- Nga P Pham et al. « Spray coating of photoresist for pattern transfer on high topography surfaces », J. Micromech. Microeng. 15 (2005) 691 - 697 ;
- Vijav Kumar Singh « Deposition of thin and uniform photoresist on three-dimensional structures using fast flow in spray coating » J. Micromech. Microeng. 15 (2005) 2339-2345 ; et
- T. Ikehara, R. Maeda « Fabrication of an accurately vertical sidewall for optical switch applications using deep RIE and photoresist spray coating », Microsyst. Technol. 12 (2005) 98 - 103.

La figure 11C montre une couche de résine RL' déposée par nébulisation.

Des recuits en présence d'un champ magnétique externe $B_R$ sont effectués après ou pendant la fabrication des capteurs pour polariser les couches de blocage et les couches « douces » (figure 11 D).

## Revendications

1. Magnétomètre intégré comportant une pluralité de capteurs magnétorésistifs multicouches ($R_1$, $R_2$, $R_3$, $R_4$) déposés sur une surface dite supérieure d'un substrat (S) sensiblement planaire, **caractérisé en ce que** :

   - ladite surface supérieure du substrat présente au moins une cavité ou protubérance (P, CP) pourvue d'une pluralité de faces inclinées ; et **en ce que** :
   - au moins quatre dits capteurs magnétorésistifs sont déposés sur quatre dites faces inclinées, présentant des orientations différentes et opposées deux à deux, chaque capteur étant sensible à une composante d'un champ magnétique externe parallèle à la face sur lequel il est déposé.

**2.** Magnétomètre intégré selon la revendication 1, dans lequel ledit substrat est de type monocristallin, et en particulier en silicium, lesdites faces inclinées correspondant à des plans cristallins du substrat.

**3.** Magnétomètre selon l'une des revendications précédentes, dans lequel ladite ou chaque cavité ou protubérance présente une forme de pyramide, ou pyramide tronquée, à base carrée ou rectangulaire.

**4.** Magnétomètre selon la revendication 3, dans lequel les axes de sensibilité ($A_{R1}$, $A_{R2}$, $A_{R3}$, $A_{R4}$) desdits capteurs sont dirigés vers ou à l'opposé de la pointe de ladite pyramide.

**5.** Magnétomètre selon l'une des revendications précédentes, dans lequel chacun desdits capteurs est constitué par deux capteurs élémentaires identiques, et dans lequel les capteurs élémentaires déposés sur des faces présentant des orientations opposées sont connectés en pont de Wheatstone.

**6.** Magnétomètre selon l'une des revendications précédentes, dans lequel lesdits capteurs sont identiques.

**7.** Magnétomètre selon l'une des revendications 1 à 5, dans lequel lesdits capteurs sont identiques sauf en ce que ceux qui sont montés sur deux faces opposées présentent une sensibilité de signe opposé.

**8.** Magnétomètre selon l'une des revendications 1 à 6, dans lequel chacun desdits capteurs est constitué par quatre capteurs élémentaires identiques montés en pont de Wheatstone, un écran magnétique (BM) étant déposé au-dessus de deux desdits capteurs élémentaires occupant des positions opposées dans ledit pont de Wheatstone.

**9.** Magnétomètre selon l'une des revendications 1 à 6, dans lequel chacun desdits capteurs est constitué par deux capteurs élémentaires (R, R') identiques sauf en ce qu'ils présentent des sensibilités de signe opposé.

**10.** Magnétomètre selon l'une des revendications précédentes, dans lequel lesdits capteurs magnétorésistifs multicouches sont choisis parmi :

   - des capteurs à magnétorésistance géante ; et
   - des capteurs à magnétorésistance tunnel.

**11.** Magnétomètre selon l'une des revendications précédentes, dans lequel au moins un accéléromètre (AM) de type microélectromécanique est intégré sur ledit substrat.

**12.** Magnétomètre selon l'une des revendications précédentes, comprenant exclusivement des capteurs magnétorésistifs déposés sur des dites faces inclinées.

**13.** Magnétomètre selon l'une des revendications précédentes, dans lequel lesdits capteurs magnétorésistifs sont disposés à l'intérieur d'un rayon inférieur ou égal à 1 mm, et de préférence inférieur ou égal à 100 $\mu$m.

**14.** Procédé de fabrication d'un magnétomètre selon l'une des revendications précédentes comportant :

   - une première étape de réalisation de ladite ou de chaque cavité ou protubérance sur ladite surface supérieure dudit substrat ;
   - une deuxième étape de réalisation desdits capteurs magnétorésistifs multicouches par des opérations successives de dépôt et de lithographie ; et
   - une troisième étape de recuit avec application d'un champ magnétique externe pour déterminer les axes de sensibilité des capteurs ainsi réalisés.

**15.** Procédé de fabrication selon la revendication 14, dans lequel ladite première étape est mise en oeuvre par gravure anisotrope dudit substrat, qui est monocristallin.

**16.** Procédé de fabrication selon l'une des revendications 14 ou 15, dans lequel ladite deuxième étape comporte au moins une opération de dépôt d'une couche homogène de résine (RL') sur la surface dudit substrat, ladite ou chaque opération de dépôt étant réalisée par nébulisation ou vaporisation de ladite résine.

**Patentansprüche**

**1.** Integriertes Magnetometer, umfassend eine Vielzahl von mehrschichtigen magnetoresistiven Sensoren ($R_1$, $R_2$, $R_3$, $R_4$), welche auf einer als obere bezeichneten Oberfläche eines im Wesentlichen ebenen Substrats (S) angeordnet sind, **dadurch gekennzeichnet, dass**:

   - die obere Oberfläche des Substrats wenigstens eine Vertiefung oder Erhöhung (P, CP) aufweist, welche mit einer Vielzahl von geneigten Seiten versehen ist; und das:
   - wenigstens vier der genannten magnetoresistiven Sensoren auf vier der genannten geneigten Seiten angeordnet sind, welche verschiedene und paarweise entgegengesetzte Ausrichtungen aufweisen, wobei jeder Sensor empfindlich ist gegenüber einer Komponente eines äußeren Magnetfelds, welches parallel zu der Seite ist, auf welcher er angeordnet ist.

2. Integriertes Magnetometer nach Anspruch 1, wobei das Substrat vom monokristallinen Typ und insbesondere aus Silizium ist, wobei die geneigten Seiten Kristallebenen des Substrats entsprechen.

3. Magnetometer nach einem der vorhergehenden Ansprüche, wobei die oder jede Vertiefung oder Erhebung eine Form einer Pyramide oder eines Pyramidenstumpfs mit quadratischer oder rechteckiger Basis aufweist.

4. Magnetometer nach Anspruch 3, wobei die Sensitivitätsachsen ($A_{R1}$, $A_{R2}$, $A_{R3}$, $A_{R4}$) der Sensoren in Richtung oder entgegengesetzt zu der Spitze der Pyramide gerichtet sind.

5. Magnetometer nach einem der vorhergehenden Ansprüche, wobei jeder der Sensoren gebildet ist durch zwei identische elementare Sensoren, und wobei die elementaren Sensoren, welche auf den entgegengesetzte Ausrichtungen aufweisenden Seiten angeordnet sind, in Form einer Wheatstone-Brücke verbunden sind.

6. Magnetometer nach einem der vorhergehenden Ansprüche, wobei die Sensoren identisch sind.

7. Magnetometer nach einem der Ansprüche 1-5, wobei die Sensoren identisch sind, bis auf dass diejenigen, welche auf zwei gegenüberliegenden Seiten angebracht sind, eine Sensitivität mit entgegengesetztem Vorzeichen aufweisen.

8. Magnetometer nach einem der Ansprüche 1-6, wobei jeder der Sensoren gebildet ist durch vier identische elementare Sensoren, welche in Form einer Wheatstone-Brücke installiert sind, wobei ein magnetischer Schirm (BM) über zwei der elementaren Sensoren angeordnet ist, welche gegenüberliegende Positionen in der Wheatstone-Brücke einnehmen.

9. Magnetometer nach einem der Ansprüche 1-6, wobei jeder der Sensoren gebildet ist durch zwei elementare Sensoren (R, R'), welche identisch sind, bis auf dass sie Sensitivitäten mit entgegengesetztem Vorzeichen aufweisen.

10. Magnetometer nach einem der vorhergehenden Ansprüche, wobei die mehrschichtigen magnetoresistiven Sensoren ausgewählt sind aus:

- Sensoren mit Riesenmagnetowiderstand; und
- Sensoren mit Tunnel-Magnetowiderstand.

11. Magnetometer nach einem der vorhergehenden Ansprüche, wobei wenigstens ein Beschleunigungsmesser (AM) vom mikroelektromechanischen Typ auf dem Substrat integriert ist.

12. Magnetometer nach einem der vorhergehenden Ansprüche, umfassend ausschließlich magnetoresistive Sensoren, welche auf den genannten geneigten Seiten angeordnet sind.

13. Magnetometer nach einem der vorhergehenden Ansprüche, wobei die magnetoresistiven Sensoren im Inneren eines Radius angeordnet sind, welcher kleiner oder gleich 1 Millimeter, und bevorzugt kleiner oder gleich 100 Mikrometer ist.

14. Verfahren zur Herstellung eines Magnetometers nach einem der vorhergehenden Ansprüche, umfassend:

- einen ersten Schritt zur Realisierung des oder jeder Vertiefung oder Erhöhung auf der oberen Oberfläche des Substrats;
- einen zweiten Schritt zur Realisierung der mehrschichtigen magnetoresistiven Sensoren durch aufeinanderfolgende Abscheidungs- und Lithographievorgänge; und
- einen dritten Schritt zum Tempern mit Anwendung eines externen Magnetfelds, um die Sensitivitätsachsen der so realisierten Sensoren zu bestimmen.

15. Verfahren zur Herstellung nach Anspruch 14, wobei der erste Schritt durchgeführt wird durch anisotrope Ätzung des Substrats, welches monokristallin ist.

16. Verfahren zur Herstellung nach einem der Ansprüche 14 oder 15, wobei der zweite Schritt wenigstens einen Vorgang einer Abscheidung einer homogenen Harzschicht (RL') auf der Oberfläche des Substrats umfasst, wobei der oder jeder Abscheidungsvorgang durch Vernebelung oder Verdampfung des Harzes realisiert ist.

**Claims**

1. An integrated magnetometer comprising a plurality of multilayer magnetoresistive sensors ($R_1$, $R_2$, $R_3$, $R_4$) deposited on a "top" surface of a substantially planar substrate (S), the magnetometer being **characterized in that**:

. said top surface of the substrate presents at least one cavity or projection (P, CP) having a plurality of inclined faces; and **in that**

. at least four of said magnetoresistive sensors are deposited on four of said inclined faces, presenting orientations that are different and opposite in pairs, each sensor being sensitive to an external magnetic field component that is parallel to the face on which it is deposited.

2. An integrated magnetometer according to claim 1, wherein said substrate is of the monocrystalline type, in particular of silicon, said inclined faces corresponding to crystal planes of the substrate.

3. An integrated magnetometer according to either preceding claim, wherein said or each cavity or projection presents the shape of a pyramid or a truncated pyramid, having a base which is square or rectangular.

4. A magnetometer according to claim 3, wherein the sensitivity axes ($A_{R1}$, $A_{R2}$, $A_{R3}$, $A_{R4}$) of said sensors are directed towards or away from the tip of said pyramid.

5. A magnetometer according to any preceding claim, wherein each of said sensors is constituted by two identical individual sensors, and wherein the individual sensors deposited on faces presenting opposite orientations are connected in a Wheatstone bridge circuit.

6. A magnetometer according to any preceding claim, wherein said sensors are identical.

7. A magnetometer according to any one of claims 1 to 5, wherein said sensors are identical except in that those that are mounted on two opposite faces present sensitivities of opposite signs.

8. A magnetometer according to any one of claims 1 to 6, wherein each of said sensors is constituted by four identical individual sensors connected in a Wheatstone bridge, a magnetic shield (BM) being deposited over two of said individual sensors occupying opposite positions in said Wheatstone bridge.

9. A magnetometer according to any one of claims 1 to 6, wherein each of said sensors is constituted by two individual sensors (R, R') that are identical except in that they present sensitivities of opposite signs.

10. A magnetometer according to any preceding claim, wherein said multilayer magnetoresistive sensors are selected from:

· giant magnetoresistance sensors; and
· tunnel magnetoresistance sensors.

11. A magnetometer according to any preceding claim, wherein at least one accelerometer (AM) of microelectromechanical type is integrated on said substrate.

12. A magnetometer according to any preceding claim, exclusively comprising magnetoresistive sensors arranged on said inclined faces.

13. A magnetometer according to any preceding claim, wherein said magnetoresistive sensors are arranged within a radius that is less than or equal to 1 millimeter, and preferably less than or equal to 100 micrometers.

14. A fabrication method for fabricating a magnetometer according to any preceding claim, the method comprising:

· a first step of making said or each cavity or projection in or on said top surface of said substrate;
· a second step of making said multilayer magnetoresistive sensors by successive deposition and lithographic operations; and
· a third step of annealing with an external magnetic field being applied in order to determine the sensitivity axes of the sensors made in this way.

15. A fabrication method according to claim 14, wherein said first step is implemented by anisotropic etching of said substrate, which substrate is monocrystalline.

16. A fabrication method according to claim 14 or claim 15, wherein said second step includes at least one operation of depositing a uniform layer of resin (RL') on the surface of said substrate, the or each deposition operation being performed by spray-coating or vaporizing said resin.

FIG.1A

FIG.1B

FIG.3B

FIG.2

FIG.3A

FIG.4

FIG.5A

FIG.5B

FIG.6

FIG.7

FIG.8

FIG.9

FIG.10

FIG.11A

FIG.11B

FIG.11C

FIG.11D

FIG.12

FIG.13A

FIG.13B

## RÉFÉRENCES CITÉES DANS LA DESCRIPTION

**Documents brevets cités dans la description**

- US 2009027048 A

- US 2008169807 A

**Littérature non-brevet citée dans la description**

- Magnétorésistance géante et électronique de spin. **M. HEHN ; F. MONTAIGNE ; A. SCHUHL.** Techniques de l'Ingénieur. E 2 135
- **J. DAUGHTON et al.** Magnetic Field Sensors Using GMR Multilayer. *IEEE Transactions on magnetics,* Novembre 1994, vol. 30 (6
- **M. TONDRA et al.** Picotesla field sensor design using spin-dependent tunneling devices. *Journal of Applied Physics,* 01 Juin 1998, vol. 83 (11), 6688-6690
- **CHII-RONG YANG et al.** Study on anisotropic silicon etching characteristics in various surfactant-added teramethyl ammonium hydroxide water solutions. *J. Micromech. Microeng.,* 2005, vol. 15, 2028

- **NGA P PHAM et al.** Spray coating of photoresist for pattern transfer on high topography surfaces. *J. Micromech. Microeng.,* 2005, vol. 15, 691-697
- **VIJAV KUMAR SINGH.** Deposition of thin and uniform photoresist on three-dimensional structures using fast flow in spray coating. *J. Micromech. Microeng.,* 2005, vol. 15, 2339-2345
- **T. IKEHARA ; R. MAEDA.** Fabrication of an accurately vertical sidewall for optical switch applications using deep RIE and photoresist spray coating. *Microsyst. Technol.,* 2005, vol. 12, 98-103